(19) Europäisches Patentamt / European Patent Office / Office européen des brevets

(11) **EP 2 685 636 B1**

(12) **EUROPEAN PATENT SPECIFICATION**

(45) Date of publication and mention
of the grant of the patent:
**03.12.2014 Bulletin 2014/49**

(51) Int Cl.:
*H04B 1/30* (2006.01)          *H03D 3/00* (2006.01)
*H04L 27/36* (2006.01)          *H04L 27/38* (2006.01)

(21) Application number: **12176474.0**

(22) Date of filing: **13.07.2012**

(54) **A low frequency amplitude self-tuning circuit of high frequency generated quadrature signals**

Selbsteinstellende Niederfrequenz-Amplitudenschaltung aus in Hochfrequenz erzeugten Quadratursignalen

Circuit à réglage automatique d'amplitude à basse fréquence des signaux en quadrature générés à haute fréquence

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.01.2014 Bulletin 2014/03**

(73) Proprietor: **CSEM Centre Suisse d'Electronique et de**
**Microtechnique SA**
**2002 Neuchâtel (CH)**

(72) Inventors:
• **Pengg, Franz Xaver**
  **1205 Genève (CH)**
• **Thierry Melly**
  **1005 Lausanne (CH)**

(74) Representative: **P&TS SA (AG, Ltd.)**
**Av. J.-J. Rousseau 4**
**P.O. Box 2848**
**2001 Neuchâtel (CH)**

(56) References cited:
**DE-A1-102005 045 592     US-A1- 2007 177 693**

• **WOLFRAM KLUGE ET AL: "A Fully Integrated 2.4-GHz IEEE 802.15.4-Compliant Transceiver for ZigBee(TM) Applications", IEEE JOURNAL OF SOLID-STATE CIRCUITS, IEEE SERVICE CENTER, PISCATAWAY, NJ, USA, vol. 41, no. 12, 1 December 2006 (2006-12-01), pages 2767-2775, XP011150725, ISSN: 0018-9200, DOI: 10.1109/JSSC.2006.884802**

**Description**

Field of the invention

The present invention concerns a circuit for high frequency quadrature signals amplitude matching in a low intermediate frequency receiver, in particular a self-tuning circuit.

Description of related art

A radio-frequency (RF) signal, when received by a receiver, is shifted to a frequency near or in the base band in order to process it. In this context the expression "radio-frequency" indicates the range of frequencies between 3 kHz and 300 GHz, in particular between 300 MHz and 6 GHz. The receiver can for example be used as part of a wireless sensor node, a medical device (hearing aids, insulin pump control, pacemaker, etc), a device for a body area network (BAN), a high performance receiver for GPS applications, etc.

The frequency down-conversion in a RF receiver is performed by a mixer which translates the frequency of the received signal from the RF frequency to a lower frequency, named intermediated frequency or IF, or to the base band.

The frequency down-conversion is usually implemented such that ideally only the signal in the radio-frequency (RF) spectrum is present in the low-frequency spectrum whereas interferers at the image frequency are suppressed.

In the case of a direct conversion architecture of the receiver, the mixer translates the received signal in the base band. In this case the image coincides with the desired signal since the frequency of the local oscillator is the same as the frequency of the RF signal and then an image rejection is not necessary. However mismatches between the two quadrature paths can cause some problems. However this kind of architecture suffers from other drawbacks as for example DC offsets, flicker noise and the non linearity of the second order.

In a low intermediate frequency (IF) receiver architectures, where signal and image are very close to each other, suppression of the image cannot be achieved by filtering the incoming RF-signal, as for example in a superheterodyne type receiver, but it requires image rejection within the down-conversion procedure by appropriately recombining the IF-signal (in-phase signal or "I"-channel) and its 90° phase-shifted retarded version (quadrature-phase signal or "Q"-channel). The image-rejection capability of this down-conversion procedure depends on the accuracy of the 90° phase difference and the matching of amplitudes between the I- and Q-channels at intermediate frequency.

In this context the expression "intermediate frequency" or IF designates a frequency between the RF frequency of the received signal and the base band. In particular, in the case of a low IF architecture for the receiver, the expression "low intermediate frequency" or "low IF" designates a frequency having a value in the order of magnitude of the signal channel, for example about 100 kHz in the case of a GSM signal.

As described for example in the document "LC Quadrature Generation In Integrated circuits", K. T. Christensen, Technical University of Denmark and Nokia Mobile Phones, ISCAS 2001, the 2001 IEEE International Symposium on circuits and systems, 6-9 May 2001, ISBN 978-0-7803-6685-5, p. 41-44, quadrature signals are usually generated either at the level of the local oscillator (LO) or in the RF signal path.

In the case of the generation of quadrature signals at the level of the local oscillator (LO), the RF signal path is split in two paths, one of which is multiplied with a first LO signal and the other one is multiplied by a second LO signal in quadrature with the first one. In this case the local oscillator (LO) can be for example generated in quadrature with a quadrature Voltage Controlled Oscillator (VCO) or by dividing a double frequency VCO. This solution requires a circuitry with rather high current consumption.

In the case of the generation of quadrature signals in the RF signal path, the RF signal path is split in two paths which are in quadrature. Usually, in the in-phase signal path "I" the poly-phase filter represents a high-pass filter with +45° phase-shift at its corner frequency, whereas it represents a low-pass filter with -45° phase-shift at its corner frequency in the quadrature-phase signal path "Q". The poly-phase filter in general comprises integrated passive components, in particular resistors and capacitors. For this reason it is named in the following and in the Figures also with the expression "RCCR".

The implementation of a passive RC-CR 90° phase-shifting in the RF-signal path is known. However known solutions use several cascaded RC-stages to cope with the amplitude mismatch due to the high process variations or temperature variations of the integrated passive resistor and capacitor components. In this context the expression "multi-stage poly-phase filter" indicates a poly-phase filter which is formed by a set of recursive filtering elements, each of these recursive elements being a "single-stage poly-phase filter".

The process variations depend on the etching quality, on side diffusion effects, on the doping dose of the silicon slice, on the polysilicon grain size, crystal defects, impurities, etc.

A multi-stage poly-phase filter uses a chain of single-stage poly-phase filters with deliberately shifted corner frequencies to guarantee better amplitude matching between the generated quadrature signals at the frequency of interest. However it inherently presents gain losses due to the deliberately detuned stages .Finally it has the drawback of increased power consumption due to the additional buffers, i.e. amplifiers, that should be included to compensate for the signal attenuation.

The document "A fully integrated 2.4 GHz IEEE 803.15.4-Compliant Transceiver for ZigBee Applications", W. Kulge et al., IEEE Journal of Solid-State Circuits, Vol. 41, No 12, December 2006, p. 2767-2775 describes a CMOS radio transceiver comprising a two-stage poly-phase filter in the RF signal path.

The document "Analysis, Design, and Optimization of RF CMOS Polyphase Filters" Doctoral thesis of Zisan Zhang at the "Universität Duisburg-Essen", 2005, describes RF CMOS polyphase filters.

Further, US 2007/0177693 describes an integrated circuit arrangement for converting an HF band pass signal to a low IF quadrature signal using a poly-phase filter.

An aim of the present invention is to reduce the current consumption of a low intermediate frequency receiver in which the signal quadrature is performed in the RF signal path.

Another aim of the present invention is to avoid the drawbacks related to the use of a multi-stage poly-phase filter in a low intermediate frequency receiver.

Another aim of the present invention is to obtain amplitude matching between two RF paths in quadrature of a receiver for a low intermediate frequency receiver without using calibration cycles or external tuning.

<u>Brief summary of the invention</u>

According to the invention, these aims are achieved by means of an self-tuning circuit for quadrature signals amplitude matching in a low intermediate frequency receiver according to claim 1.

The self-tuning circuit for quadrature signals amplitude matching in a low intermediate frequency receiver according to the invention comprises

- a poly-phase filter for filtering a received signal and generating two filtered signals being in quadrature
- a frequency down-conversion mixer for shifting the two filtered signals to a low intermediate frequency and generating an in-phase and a quadrature down-converted signals
- an amplifying stage comprising an in-phase amplifier for amplifying the in-phase down-converted signal and a quadrature amplifier for amplifying the quadrature down-converted signal.

Advantageously the poly-phase filter is a single-stage poly-phase filter. As known, it comprises integrated passive components, in particular resistors and capacitors.

The use of a single-stage poly-phase filter allows to reduce the number of integrated passive components and then of the gain losses. It allows also a better performance of the receiver front-end since a voltage gain higher than the solutions with the multi-stage poly-phase filter can be maintained throughout the signal path at radio frequency. It allows also to reduce or eliminate the number of buffers, i.e. amplifiers, which are usually needed to compensate for the higher signal attenuation of a multi-stage poly-phase filter.

Integrated passive components, as resistors or capacitors, are designed for absolutes values $R_0$ and $C_0$ respectively for specific circuit blocks, in the present case the poly-phase filter. However process variations during the realisation of these integrated passive components on a silicon slice in general cause a deviation from the designed value of these resistors or capacitors. In particular a resistor on a silicon slice has a value R different from $R_0$. The same considerations are valid for the designed value of the capacitor $C_0$ and its effective value C on the silicon slice. Factors $k_r$ and $k_c$ are then introduced as deviation of R from its designed value $R_0$ and as deviation of C from its designed value $C_0$ respectively, according to the following relations

$$R = k_r \cdot R_0$$

$$C = k_c \cdot C_0$$

These deviation factors $k_r$ and $k_c$ are not known a priori and depend on multiple factors, such as the etching quality, the side diffusion effects, the doping dose of the silicon slice, the polysilicon grain size, crystal defects, impurities, etc. Temperature will also have an influence on the absolute values of these passive integrated components. Typically, deviations can be of the order of 20%-30% of the designed values.

In order to cope with the amplitude mismatch between the I- and Q-channels due to process variations and temperature variations influencing the integrated passive components, according to the invention each of the in-phase and quadrature amplifier have a gain depending on the deviation factor of these integrated passive components. In a preferred embodiment each of the bias circuits of the in-phase and quadrature amplifier comprise integrated passive components which are matched to the integrated passive components of the poly-phase filter. In other words the passive integrated components like resistors and capacitors used to generate bias currents for the in-phase and quadrature amplifiers at intermediate frequency are matched to the components used in the single-stage poly-phase filter. In this context the expression "matched to the components used in the single-stage poly-phase filter" indicates that the resistors and the capacitors controlling, through their respective bias currents, the transconductances of the in-phase and quadrature amplifiers have the same deviation factor $k_r$ respectively $k_c$ from the designed values as the resistors and capacitors used in the poly-phase filter.

In the state of the art different techniques are known for obtaining a matching between integrated passive components. For example, since an integrated resistor is a strip of a resistive layer on a silicon slice, two resistors are matched if they have the same geometry and orientation. The geometry of a resistor is its physical dimension on a silicon slice and the orientation its physical position on a silicon slice to guide the current through it. For example a resistor having a design value of 4 kΩ in the bias current generating circuit for the in-phase or quadrature amplifier has the same layout than a corresponding resistor of 4 kΩ in the poly-phase filter. If a resistor of 40 kΩ is needed in this bias circuit, it is made up of 10 resistors of 4 kΩ in series, each of which having the same layout than a corresponding resistor of 4 kΩ in the poly-phase filter.

Other techniques, i.e. interdigitation, 45° orientation, thermal effect compensation can be also used for obtaining a matching between integrated resistors. Identical geometries, a common centroid arrangement, the location in a low stress area on a silicon slice and/or far away from power devices, etc. are known techniques for obtaining a matching between integrated capacitors.

Since the techniques for obtaining the matching between integrated passive components are not an object of the present invention, it is made reference to the slides "Layout of Analog CMOS integrated circuit - Part 3 - Passive components: Resistors and Capacitors" of Prof. Franco Maloberti, which are integrated by reference.

In a preferred embodiment the bias circuit of the in-phase amplifier comprises a first PTAT (proportional-to-absolute-temperature) module for generating the bias current of the in-phase amplifier. This first PTAT module comprises a matched version of the resistors of the single-stage poly-phase filter PPF.

Advantageously the bias circuit of the quadrature amplifier comprises a second PTAT module for generating the bias current of the in-phase amplifier. This second PTAT module comprises a closely matched version of the capacitors of the single-stage poly-phase filter PPF.

An example of a PTAT module is described in the document EP2421214 filed by the same applicant and here enclosed for reference.

Advantageously the in-phase and the quadrature amplifiers are arranged so that their transconductances (or gains) $gm_i$ respectively $gm_q$ are related as follows:

$$\frac{gm_q}{gm_i} = \frac{1}{k_r \cdot k_c}$$

wherein $k_r$ is the deviation from the design value of a resistor and $k_c$ is the deviation from the design value of a capacitor used in the single-stage poly-phase filter.

In other words the transconductances of the in-phase and quadrature amplifiers are controlled by the bias circuits of the in-phase and quadrature amplifier. Each of the bias circuits of the in-phase and quadrature amplifiers comprises integrated passive components which are matched to the integrated passive components of the poly-phase filter.

In a preferred embodiment the in-phase and quadrature amplifiers are arranged so that their transconductances are controlled by their bias circuits, each of these bias circuits comprising integrated passive components which are matched to the integrated passive components of the poly-phase filter.

In a preferred embodiment the in-phase and/or the quadrature amplifier are arranged so as to operate in weak inversion, i.e. they comprise one (or more) transistors constituting the active stages of the amplifier and which operate in weak inversion. In this context the expression "weak inversion" designates the subthreshold region of a transistor. For example, for N-type CMOS transistor is in weak inversion if $V_{GS} < V_{th}$, where $V_{th}$ is the threshold voltage of the transistor, $V_{GS}$ the voltage between its gain and its source and $V_{DS}$ the voltage between its drain and its source. In such a case the transconductances of these active stages, thus their voltage gain, depend linearly on the DC-current through the active devices.

However the invention is not limited to the use of amplifiers operating in weak inversion. In fact, according to another embodiment, the in-phase and the quadrature amplifier are arranged so as to operate in strong inversion, i.e. they comprise one (or more) transistors constituting the active stages of the amplifier and which operate in strong inversion. The expression "strong inversion" designates the active region of a transistor. For example, for N-type CMOS transistor is in strong inversion if $V_{GS} > V_{th}$ and in saturation if $V_{DS} > (V_{GS} - V_{th})$. In such a case the in-phase and the quadrature amplifiers comprise bias circuits generating output currents proportional to the square of the deviations factors kr and kc, in order to satisfy the requirements for amplitude matching between "I"- and "Q"-signal paths.

The mixer of the circuit according to the invention can be a passive mixer, for example it comprises passive switches, e.g. MOS transistors operated in switching mode to perform the frequency down-conversion. In another embodiment it is an active down-conversion mixer, comprising e.g. Gilbert cells.

In one embodiment the signal paths between the first of the two filtered signals and the output signal of the quadrature amplifier and the second filtered signal and the output signal of the in-phase amplifier respectively comprise at least one DC coupling between the circuit blocks between the poly-phase filter and the quadrature respectively in-phase amplifier. The DC-voltage level or common mode voltage is optimized for the in-phase and quadrature amplifiers but imposed on the signal paths at radio frequency before frequency down-conversion.

In another embodiment the common mode voltage for mixer is independent from the common voltage of the in-phase and quadrature amplifier, in order to give more degree of freedom for the designs of these blocks.

The circuit according to the invention allows an amplitude matching between two signals in quadrature before further base-band signal processing (channel filter, ADC, RSSI, etc.), without the need of calibration cycles or additional tuning. For this reason it is named "self-tuning" circuit.

Brief Description of the Drawings

The invention will be better understood with the aid of the description of an embodiment given by way of example and illustrated by the figures, in which:

Fig. 1 shows a schematic representation of a quadrature signal generation with amplitude matching through the biasing of the transconductances.

Fig. 2 shows a schematic representation (DC biasing not shown) of one embodiment of the circuit according to the invention.

Fig. 3 shows an embodiment of a DC-coupling from the RF paths to the in-phase and quadrature amplifiers.

Fig. 4 shows an embodiment of the differential single-stage poly-phase filter belonging to the circuit according to the invention, with its common mode voltage applied through high value isolation resistors R' and R" respectively.

Fig. 5 shows an embodiment of a part of the circuit according to the invention, with independent common mode voltages for the mixer and the in-phase and quadrature amplifiers.

Fig. 6 shows a bias current generation for an in-phase and/or quadrature amplifier working in strong inversion.

Detailed Description of possible embodiments of the Invention

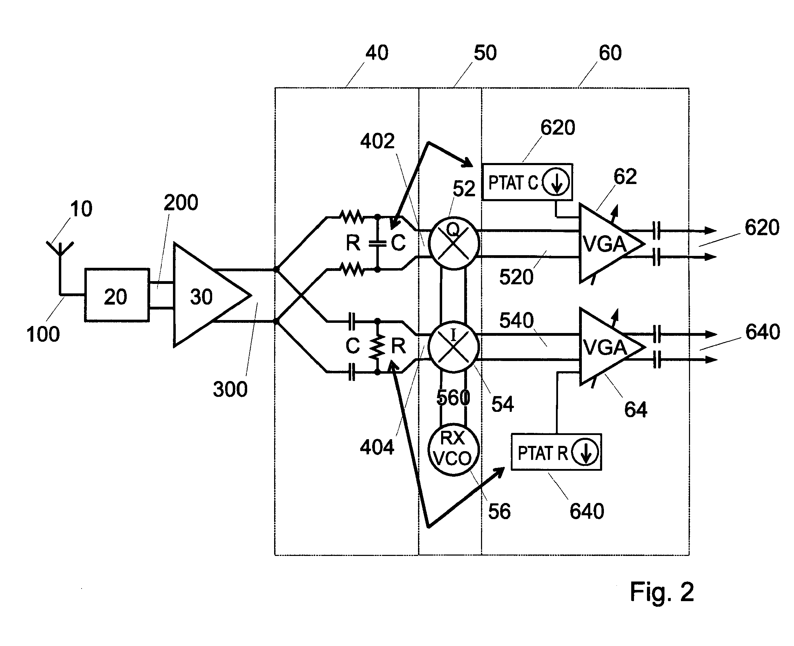

As shown on Fig. 2, a signal 100, possibly amplified by a LNA 30, is received by an antenna 10. After the antenna 10 receiving the RF signal, which is single-ended in most applications, there is sometimes a SAW (Surface Acoustic Wave) filter, not illustrated in the Fig. 2, for attenuating the signals outside of the signal frequency band. The SAW filter can be followed by a balun 20 comprising for example an inductive transformer, to generate differential signals 200 before applying them to the differential LNA 30. The balun 20 is in general an external element, which is not integrated in the circuit comprising the receiving chain. It is in general placed between a SAW filter and the LNA 30, if the SAW filter has single ended input and output ports. Solutions with integrated balun are also possible.

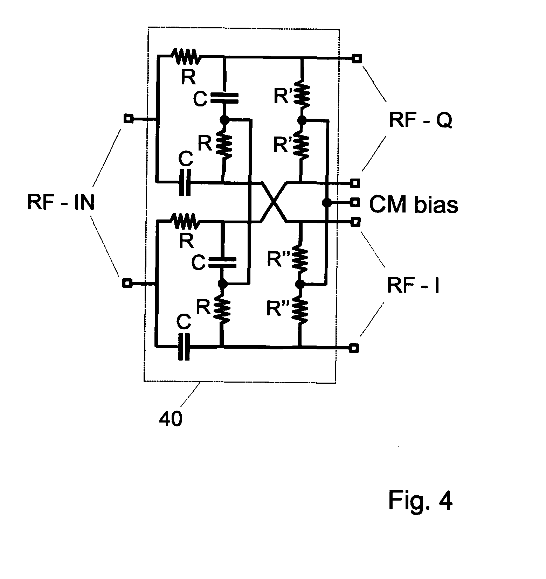

A poly-phase filter 40 follows the LNA 30 to generate from the amplified signal 200 two signals 402, 404 with a relative phase-shift of 90°. Advantageously the poly-phase filter 40 is a single-stage poly-phase filter 40 comprising integrated passive components R and C. The detailed configuration of a differential poly-phase filter 40 of Fig. 2, shown in Fig. 4, comprises per signal polarity of the differential signal two resistors R having the same value and two capacitors C having the same value, where one resistor-capacitor pair RC per polarity is forming a low-pass filter, another capacitor-resistor pair CR per polarity is forming a high-pass filter.

After the poly-phase filter 40 a frequency down-conversion mixer 50 shifts the two filtered signals 402, 404 to a low intermediate frequency and generates in-phase down-converted signal 540 and quadrature down-converted signal 520, respectively. The frequency of the signal generated by the local oscillator 56 is equal to the difference between the RF frequency and the desired IF frequency.

After the mixer 50 there is an amplifying stage 60 comprising an in-phase amplifier 64 for amplifying the in-phase down-converted signal 540 and a quadrature amplifier 62 for amplifying the quadrature down-converted signal 520. The amplifiers 64, 62 are variable gain amplifiers (VGA).

The use of a single-stage poly-phase filter 40 allows to reduce the number of integrated passive components and avoids additional gain losses. It thus allows a better performance of the receiver front-end since a voltage gain higher than the solutions with the multi-stage poly-phase filter can be maintained throughout the signal path at radio frequency.

During the design phase of the poly-phase filter, integrated passive components as resistors or capacitors are designed to have absolute values $R_0$ and $C_0$ respectively. However process variations during the realisation of these integrated passive components on a silicon slice in general cause a deviation from the design value of these resistors or capacitors. In particular a resistor being designed to have an absolute value $R_0$ will have on a silicon slice a value R different from $R_0$. The same considerations are valid for the designed value of the capacitor $C_0$ and its effective value C on the silicon slice. Factors $k_r$ and $k_c$ are then introduced as deviation of R from its designed value $R_0$ and as deviation of C from its designed value $C_0$ respectively, according to the following relations

$$R = k_r \cdot R_0 \qquad\qquad (1)$$

$$C = k_c \cdot C_0 \qquad\qquad (2)$$

These deviation factors $k_r$ and $k_c$ are not known a priori and depend on multiple factors.

In order to cope with the amplitude mismatch between the I- and Q-channels due to the process variations and temperature variations influencing integrated passive components and in order to have the signals 620, 640 at the output of the amplifiers 62, 64 of the same amplitude, according to the invention each of the in-phase and quadrature amplifier 62, 64 have a gain depending on to the deviation factors $k_r$ and $k_c$ of these integrated passive components. In other words the in-phase and quadrature amplifiers 62, 64, in particular the circuit blocks, i.e. the bias circuits, defining their operating point, comprise integrated passive components R, C matched to the integrated passive components of the poly-phase filter 40.

As discussed, in the state of the art different techniques are known for obtaining a matching between integrated passive components.

In a preferred embodiment the bias circuit of the in-phase amplifier comprises a first PTAT 640 (proportional-to-absolute-temperature) module for generating the bias current of the in-phase amplifier 64. This first PTAT module 640 comprises a matched version of the resistors R of the single-stage poly-phase filter PPF 40, as indicated schematically by the arrow in Fig. 2 between a resistors R of the poly-phase filter 40 and the PTAT 640.

Advantageously the bias circuit of the quadrature amplifier comprises a second PTAT module 620 for generating the bias current of the quadrature amplifier 62. This second PTAT module 620 comprises a closely matched version of the capacitors C of the single-stage poly-phase filter PPF 40, as indicated schematically by the arrow in Fig. 2 between a capacitor C of the poly-phase filter 40 and the PTAT 620.

An example of a PTAT module is described in the document EP2421214 filed by the same applicant and here enclosed for reference.

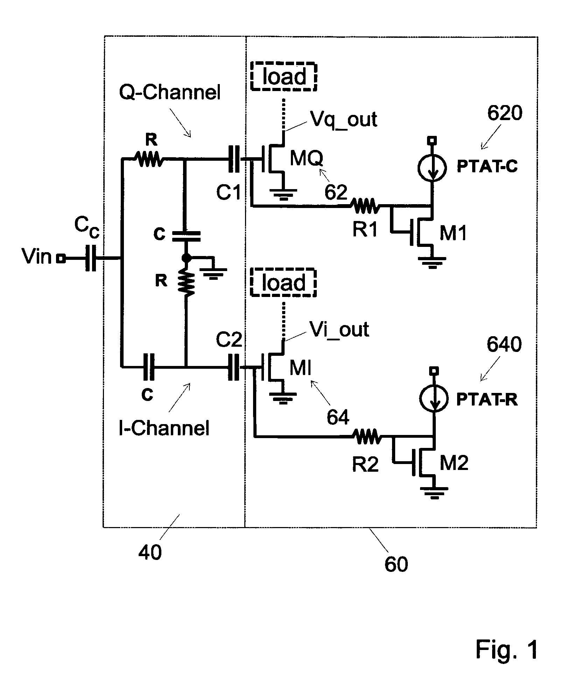

Fig. 1 shows a view of a schematic representation of a quadrature signal generation with amplitude matching through the biasing of the transconductances. The poly-phase filter 40 is coupled by capacitors C1, C2 to the amplifying stage 60 which comprises the active transconductance stages MI and MQ, corresponding to the in-phase and quadrature amplifiers 62, 64 of Fig. 2 respectively. MI and MQ are biased through the isolation resistors R1 and R2 by a bias circuit comprising the PTAT-C with current mirror transistor M1 and the PTAC-R with current mirror transistor M2 respectively.

The active transconductances have the same load, indicated in Fig. 1 for simplicity by a rectangle. This load can be a generic resistor $R_{IF}$:

The signals amplified by the two active transconductances MQ, MI are of course in quadrature: in particular the active transconductance MI amplifies the in-phase signal and the active transconductance MQ the quadrature signal.

The output voltage of the active transconductance MI, indicated by $V_{i\_out}$ in Fig. 1, is given by

$$V_{i\_out} = V_{in} \cdot K(j\varpi_0) \cdot gm_i \cdot R_{IF} \qquad (3)$$

where $V_{in}$ is the input signal to the poly-phase filter 40, $K(j\overline{\omega}_0)$ a factor of the transfer function, common to both "I"- and "Q"-signal paths, $g_{mi}$ the transconductance of the gain stage MI and $R_{IF}$ its generic load. $\overline{\omega}_0$ is given by

$$\varpi_0 = \frac{1}{R_0 C_0} \qquad (4)$$

The output voltage of the active transconductance MQ, indicated by $V_{q\_out}$ in Fig. 1, is given by

$$V_{q\_out} = V_{in} \cdot K(j\varpi_0) \cdot \frac{1}{j\varpi_0 \cdot k_r R_0 \cdot k_c C_0} gm_q \cdot R_{IF} \qquad (5)$$

where $gm_q$ is the transconductance of the gain stage MQ. The absolute value of the factor

$$\frac{1}{j\varpi_0 \cdot k_r R_0 \cdot k_c C_0}$$

gives the amplitude mismatch between the I-path and the Q-path in the poly-phase filter, related to the deviations $k_r$ and $k_c$ from the design values $R_0$, $C_0$ of the passive components R and C.
Amplitude matching at the output of the amplifying stage 60 is satisfied if

$$\left| V_{i\_out} \right| = \left| V_{q\_out} \right| \qquad (6)$$

By using (3) and (5) in (6) together with (4) we obtain the requirement

$$\frac{gm_i}{gm_q} = \frac{1}{k_r \cdot k_c} \qquad (7)$$

If the relation (7) is satisfied, the amplitude matching (6) is guaranteed. In order to satisfy the relation (7), the relations

$$gm_q = k_c \cdot gm_0 \qquad (8)$$

and

$$gm_i = \frac{gm_0}{k_r} \qquad\qquad (9)$$

have to be satisfied, where $gm_0$ is the designed transconductance of the gain stages MQ and MI respectively. In other words the use, in the bias circuit of the amplifying stages 62, 64, of integrated resistors and capacitors matched to the resistors and capacitors of the poly-phase filter, thus having the same deviation factors $k_r$ and $k_c$ respectively, allows to satisfy (8) and (9).

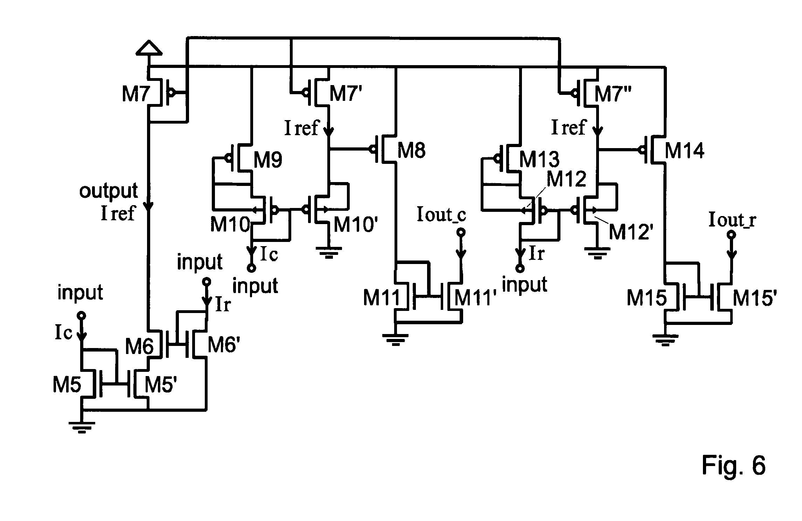

In a preferred embodiment the in-phase and the quadrature amplifier 62, 64 are arranged so as to operate in weak inversion. In such a case the transconductances of these active stages MI, MQ, thus their voltage gain, depend linearly on the DC-current through the active devices. However the invention is not limited to the use of amplifiers 62, 64 operating in weak inversion. In fact, according to another embodiment, the in-phase and the quadrature amplifier are arranged so as to operate in strong inversion. In such a case the in-phase and the quadrature amplifier comprise a bias circuit generating output currents proportional to the square of the deviations factors $k_r$ and $k_c$, as illustrated in Fig. 6, where some current mirrors allow to obtain

$$I_{out\_c} = \frac{I_c^2}{I_{ref}} \text{ and } I_{out\_r} = \frac{I_r^2}{I_{ref}} \qquad\qquad (10)$$

in order that the transconductances of the gain stages MI and MQ satisfy relation (7).

The mixer 50 of the circuit according to the invention can be a passive mixer, for example comprising passive switches, e.g. MOS transistors operated in switching mode to perform the frequency down-conversion. In another embodiment it is an active down-conversion mixer, comprising e.g. Gilbert cells.

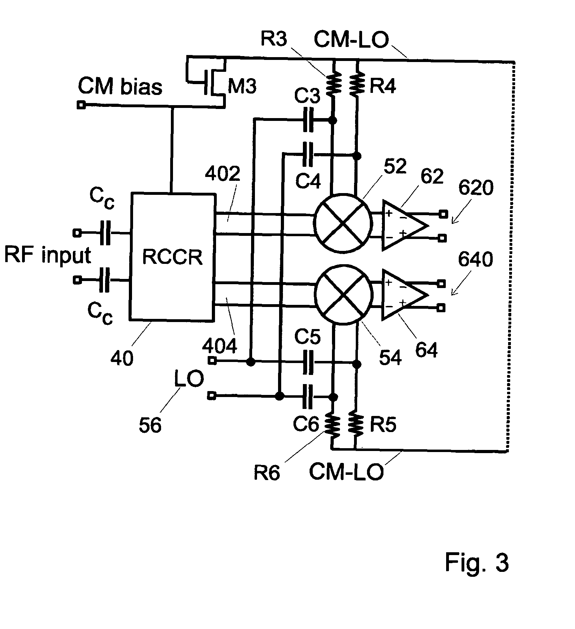

In one embodiment, illustrated in Fig. 3, the common mode voltage is applied at the level of the poly-phase filter and all stages between the first of the two filtered signals 402 and the output signal 620 of the quadrature amplifier 62 and between the second filtered signal 404 and the output signal 640 of the in-phase amplifier 64 are DC-coupled.

Fig. 4 illustrates this arrangement of the poly-phase filter 40, with the common mode voltage "CM bias" applied through high value isolation resistors R' and R with respect to the impedance of the connected node, i.e. several 10 kΩ at radio frequency or several 100 kΩ at low intermediate frequency.

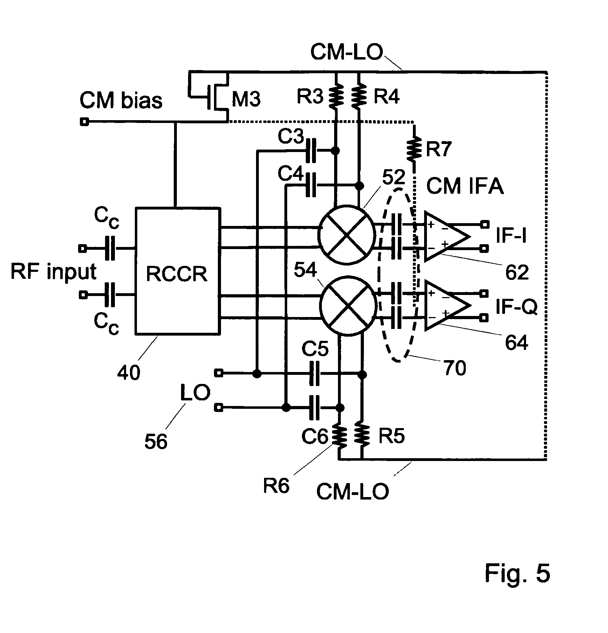

In another embodiment, illustrated in Fig. 5, the common mode voltage CM-LO for the mixer 50 is independent of the common voltage CM IFA of the in-phase and quadrature amplifiers 62, 64, in order to suppress DC-offset voltages generated at the output of the mixer and to add a degree of freedom for the design of these blocks. The illustrate embodiment comprises an AC-coupling between the mixer 50 and the amplifiers 64, 62 which is behaving like a high-pass filter.

**Claims**

1. A self-tuning circuit for quadrature signal amplitude matching in a low intermediate frequency receiver comprising

   - a poly-phase filter (40) for filtering a received signal (300) and generating two filtered signals (402, 404), said two filtered signals (402, 404) being in quadrature
   - a frequency down-conversion mixer (50) for shifting said two filtered signals (402, 404) to a low intermediate frequency (IF) and generating an in-phase (520) and a quadrature (540) down-converted signal
   - an amplifying stage (60) comprising an in-phase amplifier (64) for amplifying the in-phase down-converted signal (540) and a quadrature amplifier (62) for amplifying the quadrature down-converted signal (520) **characterised in that**

   said poly-phase filter (40) is a single-stage poly-phase filter comprising integrated passive components (R, C), wherein the values of said integrated passive components (R, C) deviate from the corresponding design values, $R_0$, $C_0$ by the deviation factors $k_r$, $k_c$, due to the manufacturing process of said self-tuning circuit, said in-phase amplifier (64) having a first transconductance, $gm_i$, and said quadrature amplifier having a second transconductance, $gm_q$, different from said first transconductance, $gm_i$, said first and second transconductances depending on said deviation factors, $k_r$, $k_c$, so as to obtain amplitude matching between the output signals (640, 620) of said in-phase amplifier (64) and said quadrature amplifier (62), despite said deviation factors, $k_r$, $k_c$, the in-phase and the quadrature amplifiers (64, 62) being arranged so that the transconductance, $gm_i$, of said in-phase amplifier (64) and the transconductance, $gm_q$, of said quadrature amplifier (62) being related by the following relation

$$\frac{gm_q}{gm_i} = \frac{1}{k_r \cdot k_c}$$

wherein $k_r$ is the deviation from the design value, $R_0$, of a resistor of said poly-phase filter (40) and $k_c$ is the deviation from the design value, $C_0$, of a capacitor (C) of said poly-phase filter (40).

2. The circuit of claim 1, said each of said in-phase and quadrature amplifier (64, 62) being arranged so that the transconductances, $gm_i$, $gm_q$, of said in-phase and quadrature amplifiers (64, 62) are controlled by the bias circuits (640, 620) of said in-phase and quadrature amplifier (64, 62), each of said bias circuits (640, 620) of said in-phase and quadrature amplifier (64, 62) comprising integrated passive components (R, C) which are matched to the integrated passive components (R, C) of said poly-phase filter (40).

3. The circuit of one of claims 1 to 2, said integrated passive components (R, C) comprising at least one resistor (R) and at least one capacitor (C).

4. The circuit of one of claims 2 or 3, said bias circuit (640) of said in-phase amplifier (64) comprising a first PTAT module (640) for generating the bias current of said in-phase amplifier, said first PTAT module (640) comprising a matched version of the resistor (R) of said poly-phase filter (40).

5. The circuit of one of claims 2 to 4, said bias circuit (620) of said quadrature amplifier (62) comprising a second PTAT module (620) for generating the bias current of said quadrature amplifier, said second PTAT module (620) comprising a matched version of the capacitor (C) of said poly-phase filter (40).

6. The circuit of one of claims 1 to 5, said in-phase and said quadrature amplifier (64, 62) being arranged so as to operate in weak inversion.

7. The circuit of one of claims 1 to 5, said in-phase and said quadrature amplifier (64, 62) being arranged so as to operate in strong inversion and comprising a circuit generating output currents proportional to the square of said deviations factors, $k_r$, $k_c$.

8. The circuit of one of claims 1 to 7, said mixer being a passive mixer.

9. The circuit of one of claims 1 to 8, comprising at least one DC coupling between the circuit blocks (52, 62; 54, 64) in the signal path between the first filtered signal (402) and the output signal of the quadrature amplifier (62) and the second filtered signal (404) and the output signal of the in-phase amplifier (64) respectively.

10. The circuit of one of claims 1 to 8, comprising independent common mode voltages for said mixer (50) and for the in-phase and quadrature amplifiers (64, 62) and an AC-coupling between the mixer (50) and the amplifiers (64, 62).

**Patentansprüche**

1. Selbsteinstellende Schaltung zur Amplitudenanpassung von Quadratursignalen in einem Niederzwischenfrequenz-Empfänger, mit:

  - einem Mehrphasenfilter (40) für das Filtrieren eines empfangenen Signals (300) und das Erzeugen von zwei filtrierten Signalen (402, 404), wobei die besagten zwei filtrierten Signale (402, 404) phasenverschoben sind
  - einem Frequenzabwärtskonvertierungsmischer (50) zur Umschaltung der besagten zwei filtrierten Signale (402, 404) auf eine Niederzwischenfrequenz (ZF) und zur Erzeugung eines herunterkonvertierten phasengleichen Signals (540) und eines herunterkonvertierten phasenverschobenen Signals (520)
- einer Verstärkungsstufe (60) mit einem phasengleichen Verstärker (64) zur Verstärkung des herunterkonvertierten phasengleichen Signals (540) und einem phasenverschobenen Verstärker (62) zur Verstärkung des herunterkonvertierten Quadratursignals (520)

**dadurch gekennzeichnet, dass**
der besagte Mehrphasenfilter (40) ein einstufiger Mehrphasenfilter mit integrierten passiven Komponenten (R, C) ist, wobei die Werte der besagten integrierten passiven Komponenten (R, C) wegen des Herstellungsprozesses der besagten selbsteinstellenden Schaltung von den entsprechenden Bemessungswerten $R_0$, $C_0$ um die Abweichungsfaktoren $k_r$, $k_c$ abweichen,
wobei der besagte phasengleiche Verstärker (64) eine erste Transkonduktanz $gm_i$ aufweist und der besagte phasenverschobene Verstärker (62) eine zweite von der ersten Transkonduktanz $gm_i$ verschiedene Transkonduktanz $gm_q$ aufweist, wobei die besagte erste und zweite Transkonduktanz von den besagten Abweichungsfaktoren $k_r$, $k_c$ abhängig sind, um eine Amplitudenübereinstimmung der Ausgangssignale (640, 620) des besagten phasengleichen Verstärkers (64) und des besagten phasenverschobenen Verstärkers (62) trotz der besagten Abweichungsfaktoren $k_r$, $k_c$ zu erreichen,
wobei die phasengleichen und phasenverschobenen Verstärker (64, 62) so angeordnet sind, dass die Transkonduktanz $gm_i$ des besagten phasengleichen Verstärkers (64) und die Transkonduktanz $gm_q$ des besagten phasenverschobenen Verstärkers (62) durch die folgende Gleichung verbunden sind:

$$\frac{gm_q}{gm_i} = \frac{1}{k_r \cdot k_c}$$

wobei $k_r$ die Abweichung in Bezug auf den Bemessungswert $R_0$ eines Widerstands des besagten Mehrphasenfilters (40) ist und $k_c$ die Abweichung in Bezug auf den Bemessungswert $C_0$ eines Kondensators (C) des besagten Mehrphasenfilters (40) ist.

2. Die Schaltung von Anspruch 1, wobei jeder besagter der besagten phasengleichen und phasenverschobenen Verstärker (64, 62) so angeordnet ist, dass die Transkonduktanzen $gm_i$, $gm_q$ der besagten phasengleichen und phasenverschobenen Verstärker (64, 62) durch die Vorspannungsschaltungen (640, 620) der besagten phasengleichen und phasenverschobenen Verstärker (64, 62) gesteuert werden, wobei jede der besagten Vorspannungsschaltungen (640, 620) der besagten phasengleichen und phasenverschobenen Verstärker (64, 62) integrierte passive Komponenten (R, C) umfassen, welche mit den integrierten passiven Komponenten (R, C) des besagten Mehrphasenfilters (40) übereinstimmen.

3. Die Schaltung von einem der Ansprüche 1 bis 2, wobei die besagten integrierten passiven Komponenten (R, C) mindestens einen Widerstand (R) und mindestens einen Kondensator (C) umfassen.

4. Die Schaltung von einem der Ansprüche 2 oder 3, wobei die besagte Vorspannungsschaltung (640) des phasengleichen Verstärkers (64) ein erstes PTAT-Modul (640) umfasst, um den Vorspannungsstrom des besagten phasengleichen Verstärkers zu generieren, wobei das besagte erste PTAT-Modul (640) eine entsprechende Version des Widerstands (R) des besagten Mehrphasenfilters (40) umfasst.

5. Die Schaltung von einem der Ansprüche 2 bis 4, wobei die besagte Vorspannungsschaltung (620) des phasenverschobenen Verstärkers (62) ein zweites PTAT-Modul (620) umfasst, um den Vorspannungsstrom des besagten phasenverschobenen Verstärkers zu generieren, wobei das besagte zweite PTAT-Modul (620) eine entsprechende Version des Kondensators (C) des besagten Mehrphasenfilters (40) umfasst.

6. Die Schaltung von einem der Ansprüche 1 bis 5, wobei die besagten phasengleichen und phasenverschobenen Verstärker (64, 62) derart angeordnet sind, um in schwacher Inversion zu funktionieren.

7. Die Schaltung von einem der Ansprüche 1 bis 5, wobei die besagten phasengleichen und phasenverschobenen Verstärker (64, 62) derart angeordnet sind, um in starker Inversion zu funktionieren und mit einer Schaltung, welche Ausgangsströme proportional zum Quadrat der besagten Abweichungsfaktoren $k_r$, $k_c$ generiert.

**8.** Die Schaltung von einem der Ansprüche 1 bis 7, wobei der besagte Mischer ein passiver Mischer ist.

**9.** Die Schaltung von einem der Ansprüche 1 bis 8, mit mindestens einer DC-Kopplung zwischen den Schaltungsblöcken (52, 62; 54, 64) auf dem Signalweg zwischen dem ersten filtrierten Signal (402) und dem Ausgangssignal des phasenverschobenen Verstärkers (62) bzw. zwischen dem zweiten filtrierten Signal (404) und dem Ausgangssignal des phasengleichen Verstärkers (64).

**10.** Die Schaltung von einem der Ansprüche 1 bis 8, mit unabhängigen Gleichtaktspannungen für den besagten Mischer (50) und für die phasengleichen und phasenverschobenen Verstärker (64, 62) und mit einer AC-Kopplung zwischen dem Mischer (50) und den Verstärkern (64, 62).

**Revendications**

**1.** Circuit à réglage automatique pour la concordance réglage d'amplitude de signaux en quadrature dans un récepteur à basse fréquence intermédiaire (LIF), comprenant:

- un filtre polyphasé (40) pour filtrer un signal reçu (300) et générer deux signaux filtrés (402, 404), lesdits deux signaux filtrés (402, 404) étant en quadrature
- un mélangeur de conversion de fréquences à une bande inférieure (50) pour transposer lesdits deux signaux filtrés (402, 404) à une fréquence intermédiaire basse (IF) et générer un signal en phase (520) et un signal en quadrature (540) transposés à une bande inférieure
- un étage d'amplification (60) comprenant un amplificateur en phase (64) pour amplifier le signal en phase transposé à une bande inférieure (540) et un amplificateur en quadrature (62) pour amplifier le signal en quadrature transposés à une bande inférieure (520)

**caractérisé en ce que**
ledit filtre polyphasé (40) est un filtre polyphasé à étage unique comprenant des composants passifs intégrés (R, C), dans lequel les valeurs desdits composants passifs intégrés (R, C) s'écartent des valeurs nominales correspondantes $R_0$, $C_0$ par les facteurs de déviation $k_r$, $k_c$, en raison du processus de fabrication dudit circuit à réglage automatique,
ledit amplificateur en phase (64) ayant une première transconductance $gm_i$ et ledit amplificateur en quadrature ayant une deuxième transconductance $gm_q$, différente de ladite première conductance $gm_i$, ladite première et deuxième conductance dépendant desdits facteurs de déviation $k_r$, $k_c$, en sorte à obtenir une concordance d'amplitude entre les signaux de sortie (640, 620) dudit amplificateur en phase (64) et dudit amplificateur en quadrature (62), malgré lesdits facteurs de déviation $k_r$, $k_c$,
les amplificateurs en phase et en quadrature (64, 62) étant configurés en sorte à ce que la transconductance $gm_i$ dudit amplificateur en phase (64) et la transconductance $gm_q$ dudit amplificateur en quadrature (62) soient dans une relation illustrée par la formule suivante :

$$\frac{gm_q}{gm_i} = \frac{1}{k_r \cdot k_c}$$

dans laquelle $k_r$ est la déviation par rapport à la valeur nominale, $R_0$, d'un résistance dudit filtre polyphasé (40) et $k_c$ est la déviation par rapport à la valeur nominale $C_0$ d'un condensateur (C) dudit filtre polyphasé (40).

**2.** Le circuit de la revendication 1, ledit chacun desdits amplificateurs en phase et en quadrature (64, 62) étant configuré de telle sorte que les transconductances $gm_i$, $gm_q$ desdits amplificateurs en phase et en quadrature (64, 62) sont contrôlés par les circuits de polarisation (640, 620) dudit amplificateur en phase et en quadrature (64, 62), chacun desdits circuits de polarisation (640, 620) dudit amplificateur en phase et en quadrature (64, 62) comprenant des composants passifs intégrés (R, C) qui concordent avec les composants passifs intégrés (R, C) dudit filtre polyphasé (40).

**3.** Le circuit de l'une des revendications 1 à 2, lesdits composants passifs intégrés (R, C) comprenant au moins une résistance (R) et au moins un condensateur (C).

**4.** Le circuit de l'une des revendications 2 ou 3, ledit circuit de polarisation (640) dudit amplificateur en phase (64) comprenant un premier module PTAT (640) pour générer le courant de polarisation dudit amplificateur en phase, ledit premier module PTAT (640) comprenant une version concordante de la résistance (R) dudit filtre polyphasé (40).

**5.** Le circuit de l'une des revendications 2 à 4, ledit circuit de polarisation (620) dudit amplificateur en quadrature (62) comprenant un deuxième module PTAT (620) pour générer le courant de polarisation dudit amplificateur en quadrature, ledit deuxième module PTAT (620) comprenant une version concordante du condensateur (C) dudit filtre polyphasé (40).

**6.** Le circuit de l'une des revendications 1 à 5, lesdits amplificateurs en phase et en quadrature (64, 62) étant configurés en sorte à fonctionner à faible inversion.

**7.** Le circuit de l'une des revendications 1 à 5, lesdits amplificateurs en phase et en quadrature (64, 62) étant configurés en sorte à fonctionner à forte inversion et comprenant un circuit générant des courants de sortie proportionnels au carré desdits facteurs de déviation $k_r$, $k_c$.

**8.** Le circuit de l'une des revendications 1 à 7, ledit mélangeur étant un mélangeur passif.

**9.** Le circuit de l'une des revendications 1 à 8, comprenant au moins un couplage à courant continu entre les blocs de circuit (52, 62; 54, 64) dans le chemin de signal entre le premier signal filtré (402) et le signal de sortie de l'amplificateur en quadrature (62) et le deuxième signal filtré (404) et le signal de sortie de l'amplificateur en phase (64) respectivement.

**10.** Le circuit de l'une des revendications 1 à 8, comprenant des tensions indépendantes de mode commun pour ledit mélangeur (50) et pour les amplificateurs en phase et en quadrature (64, 62) et un couplage à courant alterné entre le mélangeur (50) et les amplificateurs (64, 62).

Fig. 1

Fig. 2

EP 2 685 636 B1

Fig. 3

Fig. 4

Fig. 5

Fig. 6

# EP 2 685 636 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070177693 A

- EP 2421214 A

**Non-patent literature cited in the description**

- **K. T. CHRISTENSEN.** *LC Quadrature Generation In Integrated circuits*
- *ISCAS 2001, the 2001 IEEE International Symposium on circuits and systems,* 06 May 2001, ISBN 978-0-7803-6685-5, 41-44

- **W. KULGE et al.** A fully integrated 2.4 GHz IEEE 803.15.4-Compliant Transceiver for ZigBee Applications. *IEEE Journal of Solid-State Circuits,* December 2006, vol. 41 (12), 2767-2775
- Analysis, Design, and Optimization of RF CMOS Polyphase Filters. *Doctoral thesis of Zisan Zhang,* 2005